# EUROPÄISCHE PATENTSCHRIFT

(11) **EP 3 160 219 B1**
(45) Veröffentlichungstag und Bekanntmachung des Hinweises auf die Patenterteilung: **12.09.2018**
(21) Anmeldenummer: 16180010.7
(22) Anmeldetag: 18.07.2016
(51) Int. Cl.: G06T 7/00, G06T 7/73, H05K 13/00, H05K 13/04, H05K 13/08

(54) **VERFAHREN UND VORRICHTUNG ZUR PLATZIERUNG ELEKTRONISCHER BAUTEILE**
METHOD AND DEVICE FOR PLACING ELECTRONIC COMPONENTS
PROCEDE ET DISPOSITIF DE MISE EN PLACE DE COMPOSANTS ELECTRONIQUES

(30) Priorität: 23.10.2015 DE 102015220746
(43) Veröffentlichungstag der Anmeldung: 26.04.2017
(73) Patentinhaber: Ersa GmbH, 97877 Wertheim (DE)
(72) Erfinder: HOFMANN, Udo, 63934 Röllbach (DE); SINN, Wolfram, 63071 Offenbach (DE); RICHTER, Sergei, 72654 Neckartenzlingen (DE)
(74) Vertreter: DREISS Patentanwälte PartG mbB

(56) Entgegenhaltungen:
- DE-A1- 19 857 263
- DE-A1-102013 207 598
- US-A- 5 694 219

## Beschreibung

Die Erfindung betrifft ein Verfahren und eine Vorrichtung zur Platzierung elektronischer Bauteile auf einer Platine.

Bei sogenannten Rework Systemen werden elektronische Platinen, Baugruppen oder Printed Circuit Boards (PCBs) repariert oder Instand gesetzt. Hierzu werden unter Verwendung von Wärmequellen einzelne elektronische Bauteile oder Surface Mounted Devices (SMDs) von der Platine oder einem Printed Circuit Board (PCB) entlötet und wiederum neu eingelötet.

Dabei ist es aus dem Stand der Technik bekannt, die elektronischen Bauteile mittels einer Greifeinrichtung aufzunehmen und vor dem erneuten Absetzen der elektronischen Bauteile mittels eines kameraüberwachten Livebilds eine optische Überlagerung zwischen einer Bauteilunterseite und einer Platinenoberseite durch einen Anwender herzustellen.

Sobald die vom Anwender hergestellte Überlagerung ein Optimum erreicht hat, wird das Bauteil von der Greifeinrichtung auf der Platine abgesetzt. Nachteilig an dieser Vorgehensweise ist jedoch, dass die Qualität der Bauteilausrichtung bzw. Bauteilplatzierung auf der Platine maßgeblich von der Erfahrung und Qualifikation des Anwenders abhängt, so dass eine genaue Bauteilausrichtung bzw. Bauteilplatzierung auf der Platine nur von erfahrenen Anwendern durchgeführt werden kann.

Zur automatisierten Bauteilausrichtung bzw. Bauteilplatzierung ist es ferner bekannt, von der Bauteilunterseite und der Platinenoberseite jeweils ein Bild aufzunehmen und mit Hilfe einer rechnergestützten Bildverarbeitung Pins der elektronischen Bauteile und zu kontaktierende Kontaktflächen der Platinen zu erkennen und die elektronischen Bauteile basierend auf dem Ergebnis dieser Bildverarbeitung auf der Platine derart auszurichten, dass die mittels Bildverarbeitung erkannten Pins mit den mittels Bildverarbeitung erkannten Kontaktflächen in Überlagerung gebracht werden.

Diese Vorgehensweise weist jedoch Nachteile auf, da eine derartige automatisierte Bauteilausrichtung bzw. Bauteilplatzierung nicht immer zuverlässig funktioniert. Bei einer Vielzahl von Bauteilen und Platinen erfolgt die Bauteilausrichtung oder Bauteilplatzierung aufgrund von Störeinflüssen, die bspw. in der Beleuchtung, der Platinenstruktur oder der Bauteilstruktur liegen können, nicht immer zuverlässig, so dass letztendlich wieder eine manuell angesteuerte Ausrichtung durch einen Anwender erfolgen muss, deren Genauigkeit maßgeblich von Qualifikation und Erfahrung des jeweiligen Anwenders abhängt. Die DE 10 2013 207598 A1 zeigt ein Verfahren und eine Vorrichtung mit Merkmalen des Oberbegriffs der nebengeordneten Patentansprüche 1 und 10.

Der Erfindung liegt daher die Aufgabe zugrunde, ein Verfahren und eine Vorrichtung zur Platzierung elektronischer Bauteile bereitzustellen, welche die genannten Nachteile vermeiden, also insbesondere ein Verfahren und eine Vorrichtung zur Platzierung elektronischer Bauteile bereitzustellen, mit denen Bauteile in einer großen Stückzahl einfach und präzise auf einer Platine ausgerichtet werden können.

Diese Aufgabe wird durch ein Verfahren zur Platzierung elektronischer Bauteile auf einer Platine mit den Merkmalen des Anspruchs 1 gelöst. Das erfindungsgemäße Verfahren umfasst die folgenden Schritte: Platzieren eines zu platzierenden Bauteils eines ersten Bauteiltyps in einer Startposition; Erstellen eines Bauteilbilds des zu platzierenden Bauteils; Erstellen eines Platinenbereichsbilds einer Platine eines ersten Platinenbereichstyps; Berechnen eines Verfahrwegs zum Verfahren des zu platzierenden Bauteils von der Startposition in eine Endposition auf der Platine basierend auf einer Bildüberlagerung des Bauteilbilds und eines zuvor abgespeicherten Referenzbauteilbilds eines Referenzbauteils des ersten Bauteiltyps und basierend auf einer zuvor abgespeicherten Referenzstartposition, einem zuvor abgespeicherten Referenzverfahrweg des Referenzbauteils von der Referenzstartposition in eine Referenzendposition auf einer Referenzplatine des ersten Platinenbereichstyps und basierend auf einer Bildüberlagerung des Platinenbereichsbilds und eines zuvor abgespeicherten Referenzplatinenbereichsbilds der Referenzplatine; Verfahren des zu platzierenden Bauteils in die Endposition entlang des Verfahrwegs.

Im Gegensatz zum Stand der Technik erfolgt also gerade keine rechnergestützte Bildverarbeitung, bei der Pins der elektronischen Bauteile und der zu kontaktierenden Kontaktflächen der Platinen erkannt und dann überlagert werden. Vielmehr erfolgt die Berechnung des Verfahrwegs basierend auf einem abgespeicherten Referenzverfahrweg eines Referenzbauteils eines ersten Bauteiltyps auf einer Referenzplatine eines ersten Platinenbereichstyps. Geringfügige Abweichungen in der Platzierung von zu platzierenden Bauteilen des ersten Bauteiltyps auf Platinen des ersten Platinenbereichstyps sowie der Platinen selbst können durch die Bildüberlagerung des Bauteilbilds und des Referenzbauteilbilds in der Referenzstartposition sowie durch die Bildüberlagerung des Platinenbereichsbilds und des Referenzplatinenbereichsbilds ausgeglichen werden. Die Bildüberlagerung kann daher besonders vorteilhaft ohne Störeinflüsse durchgeführt werden, da eine Bildüberlagerung jeweils nur zwischen Bauteilbild und einem damit identischen oder nahezu identischen Referenzbauteilbild eines Bauteiltyps sowie zwischen Platinenbereichsbild und damit identischen oder nahezu identischen Referenzplatinenbereichsbild eines Platinenbereichstyps erfolgt. Es hat sich gezeigt, dass die Bildüberlagerung identischer oder nahezu identischer Bilder zuverlässiger durchgeführt werden kann.

Unter einem Bauteiltyp werden dabei artgleiche Bauteile verstanden, die identisch oder nahezu identisch sind. Unter Platinen eines Platinenbereichstyps werden Platinen verstanden, die einen artgleichen Bereich aufweisen, der identisch oder nahezu identisch zu Bereichen anderer Platinen ist. Daher kann das Verfahren auch für einen zweiten oder dritten Bauteiltyp und einen zweiten oder dritten Platinenbereichstyp durchgeführt werden usw.

Erfindungsgemäß ist vorgesehen, dass vor dem Abspeichern des Referenzbauteilbilds und der Referenzstartposition ein Referenzbauteilbild erstellt wird und ein Referenzbauteil in der Referenzstartposition platziert wird, wobei das Referenzbauteil dann entlang des Referenzverfahrwegs von der Referenzstartposition in die Referenzendposition auf der Referenzplatine verfahren wird und wobei der Referenzverfahrweg abgespeichert wird, wenn das Referenzbauteil in der Referenzendposition angelangt ist. Folglich wird ein Referenzbauteil des ersten Bauteiltyps zur Platzierung auf einer Referenzplatine des ersten Platinenbereichstyps eingelernt, so dass ein anschließendes Platzieren von elektronischen Bauteilen des ersten Bauteiltyps auf Platinen des ersten Platinenbereichstyps automatisiert erfolgen kann. Ein derartiges Einlernen wird in Fachkreisen auch als "teachen" bezeichnet. Vorteilhafterweise wird beim "teachen" auch ein Referenzplatinenbereichsbild der Referenzplatine erstellt und abgespeichert.

Als besonders vorteilhaft hat es sich dabei erwiesen, wenn das Verfahren des Referenzbauteils von der Referenzstartposition in die Referenzendposition manuell erfolgt. Unter manuellem Verfahren wird dabei eine manuelle Ansteuerung eines Bedienfelds einer Verfahreinrichtung durch einen Anwender verstanden. Dabei ist es besonders vorteilhaft, wenn das Verfahren des Referenzbauteils von der Referenzstartposition in die Referenzendposition von einem insbesondere erfahrenen Anwender mit guten Augen durchgeführt wird, so dass die Platzierung des Referenzbauteils auf der Referenzplatine möglichst genau erfolgen kann.

Besonders bevorzugt ist es ferner, wenn die Berechnung des Verfahrwegs durch eine Koordinatentransformation erfolgt und sich aus einer Rotation und Translation der Bildüberlagerung von Bauteilbild und Referenzbauteilbild, einer Rotation und Translation des Referenzverfahrwegs sowie einer Rotation und Translation der Bildüberlagerung von Platinenbereichsbild und Referenzplatinenbereichsbild zusammensetzt.

In einer weiteren vorteilhaften Ausgestaltung des Verfahrens ist vorgesehen, dass das zu platzierende Bauteil vor dem Verfahren von einer Greifeinrichtung gegriffen und angehoben wird.

Vorteilhafterweise wird das zu platzierende Bauteil nach dem Verfahren auf der Platine in der Endposition abgesetzt oder in der Endposition auf die Platine fallen gelassen. Dabei ist es möglich, dass die Greifeinrichtung das Bauteil in einer zuvor festgelegten Höhe freigibt, so dass dieses schwerkraftunterstützt in die Endposition auf der Platine fällt.

Um ein Erstellen des Bauteilbilds oder des Referenzbauteilbilds von einer Bauteilunterseite zu vereinfachen ist es besonders vorteilhaft, wenn das Platzieren des Bauteils in der Startposition auf einer Glasplatte erfolgt. In diesem Falle werden das Bauteilbild und/oder das Referenzbauteilbild in der Startposition erstellt. Zur insbesondere manuellen Platzierung des Bauteils oder des Referenzbauteils durch einen Anwender auf der Glasplatte weist die Glasplatte vorteilhafterweise Markierungen zur Positionierung der Bauteile oder Referenzbauteile auf.

Zusätzlich zu den Markierungen zur Positionierung der Bauteile kann die Glasplatte sogenannte Fiducials aufweisen, die zu einem sogenannten Mapping verwendet werden können und dazu dienen, beim Mapping einen Abgleich einer von oben auf das Bauteil gerichteten Kamera und einer von unten auf das Bauteil gerichteten Kamera derart zu unterstützen, dass das Bauteilbild oder Referenzbauteilbild in ein Bild des Bauteils oder Referenzbauteils, das von der Bauteiloberseite erstellt wurde, eingerechnet werden kann.

Besonders vorteilhaft ist es, wenn die Bauteile und Platinen jeweils derart markiert sind, dass eine Bauteilorientierung mittels einer Kamera erkennbar ist. Insbesondere kann dazu vorgesehen sein, dass Bauteile und Platinen, welche üblicherweise rechteckig ausgebildet sind, im Bereich einer Ecke eine optische Markierung aufweisen, mittels derer durch eine Kamera die Bauteilorientierung festgestellt werden kann. Beispielsweise kann dazu vorgesehen sein, dass die Bauteile eine sogenannte Pin-1-Erkennung aufweisen. Wenn die Glasplatte Markierungen zur Positionierung der Bauteile aufweist ist es besonders bevorzugt, wenn die Markierungen derart ausgebildet sind, dass sie eine Grundposition zu Positionierung der Bauteile vorgeben. Dies ist besonders vorteilhaft, da es sich gezeigt hat, dass das erfindungsgemäße Verfahren dann besonders gut funktioniert, wenn Bauteile mit einem Winkelversatz von weniger als 45° gegenüber der Grundposition auf der Glasplatte angeordnet werden.

Besonders bevorzugt ist es ferner, wenn das Platinenbereichsbild und das Referenzplatinenbereichsbild von einer Platinenoberseite aufgenommen werden.

Die eingangs genannte Aufgabe wird auch gelöst durch eine Vorrichtung zur Platzierung elektronischer Bauteile mit den Merkmalen des Anspruchs 11, welche dazu ausgelegt ist, das Verfahren nach wenigstens einem der Ansprüche 1 bis 10 auszuführen. Diese Vorrichtung zeichnet sich dadurch aus, dass die Vorrichtung wenigstens eine, vorzugsweise zwei Kameras aufweist, die zum Erstellen des Bauteilbilds, des Referenzbauteilbilds, des Platinenbereichsbilds und des Referenzplatinenbereichsbilds ausgelegt sind, dass die Vorrichtung eine Steuereinrichtung aufweist, die zur Berechnung des Verfahrwegs ausgelegt ist, dass die Steuereinrichtung eine Speichereinrichtung aufweist, die zur Abspeicherung des Referenzbauteilbilds, der Referenzstartposition, des Referenzverfahrwegs und des Referenzplatinenbereichsbilds ausgelegt ist und dass die Vorrichtung eine Greifeinrichtung zum Greifen der zu platzierenden Bauteile aufweist.

In einer vorteilhaften Ausgestaltung der Vorrichtung ist vorgesehen, dass die Vorrichtung eine Antriebseinheit aufweist, die zum Verfahren der Greifeinrichtung entlang des Verfahrwegs ausgelegt ist. Besonders bevorzugt ist es dabei, wenn die Greifeinrichtung vorzugsweise in mindestens 3 Achsen beweglich ausgebildet ist. Vorteilhafterweise ist die Antriebseinheit zum Verfahren der Greifeinrichtung entlang des Verfahrwegs von der Steuereinrichtung ansteuerbar.

In einer besonders vorteilhaften Ausgestaltung der Vorrichtung ist vorgesehen, dass die Greifeinrichtung eine vakuumbetriebene Unterdruckgreifeinrichtung aufweist. Mittels einer derartigen Unterdruckgreifeinrichtung können die Bauteile an der Startposition angehoben werden, mittels der Antriebseinheit entlang des Verfahrwegs verfahren werden und an der Endposition abgesetzt werden. Eine derartige vakuumbetriebene Unterdruckgreifeinrichtung wird in Fachkreisen auch als Platzierdüse bezeichnet. Die Unterdruckgreifeinrichtung oder Platzierdüse ist vorteilhafterweise austauschbar ausgebildet, wobei für Bauteile des ersten Bauteiltyps eine Platzierdüse des ersten Düsentyps verwendet wird und für Bauteile eines zweiten Bauteiltyps gegebenenfalls eine Platzierdüse eines zweiten Düsentyps verwendet wird. Zur Identifikation der verschiedenen Düsentypen kann vorgesehen sein, dass die Platzierdüse Identifikationsmerkmale aufweist, die optisch identifiziert werden können. Mittels der Unterdruckgreifeinrichtung können zu platzierende Bauteile vorteilhafterweise von einer Bauteiloberseite gegriffen oder angesaugt werden. Es ist jedoch auch denkbar, dass die Greifeinrichtung als ein Greifbacken aufweisender Greifer ausgebildet ist, mittels dem zu platzierende Bauteile von einer Bauteilseite oder einem Bauteilrand gegriffen werden können.

Erfindungsgemäß zeichnet sich die Vorrichtung dadurch aus, dass die Vorrichtung eine Glasplatte zur Platzierung der Bauteile in der Startposition aufweist. Die Verwendung einer Glasplatte zur Platzierung der Bauteile ist besonders vorteilhaft, da das Bauteilbild und das Referenzbauteilbild so auf einfache Art und Weise von einer Bauteilunterseite erstellt werden können. Zur Platzierung der Bauteile weist die Glasplatte vorteilhafterweise Markierungen zur Positionierung der Bauteile auf.

Um zu verhindern, dass die Platinen in der Vorrichtung verrutschen ist es besonders vorteilhaft, wenn die Vorrichtung einen Platinenhalter aufweist, der zur ortsfesten Befestigung der Platinen ausgelegt ist.

Weitere Einzelheiten und vorteilhafte Weiterbildungen sind der nachfolgenden Beschreibung zu entnehmen anhand derer die Erfindung näher beschrieben und erläutert ist.

Es zeigen:
- Figur 1: eine schematische Darstellung einer erfindungsgemäßen Vorrichtung zur Platzierung elektronischer Bauteile auf einer Platine beim sogenannten Teachen;
- Figur 2: einen Ausschnitt der erfindungsgemäßen Vorrichtung gemäß Figur 1 in einer Seitenansicht mit einem auf einer Glasplatte angeordneten Bauteil;
- Figur 3: einen Ausschnitt der der erfindungsgemäßen Vorrichtung gemäß Figur 1 in einer Seitenansicht mit einer Platine;
- Figur 4: eine schematische Darstellung des Verfahrensschritts der Bildüberlagerung eines Bauteilbilds und eines Referenzbauteilbilds gemäß des erfindungsgemäßen Verfahrens; und
- Figur 5: eine schematische Darstellung des Verfahrensschritts der Bildüberlagerung eines Platinenbereichsbilds und eines Referenzplatinenbereichsbilds gemäß des erfindungsgemäßen Verfahrens.

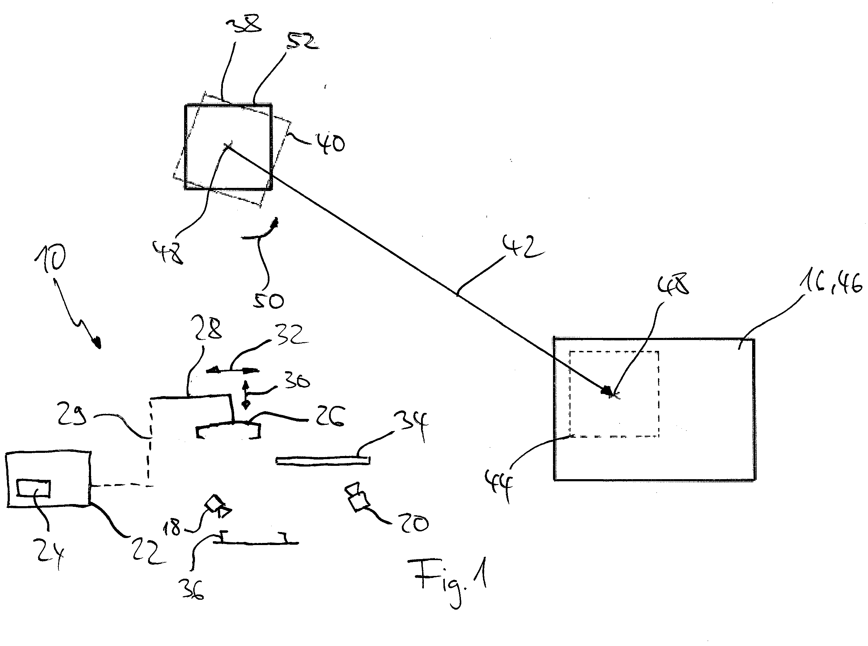

Die Figuren 1 bis 5 dienen insgesamt zur Beschreibung einer erfindungsgemäßen Vorrichtung 10 sowie eines erfindungsgemäßen Verfahrens. Sich entsprechende Bauteile und Elemente sind in den Figuren mit den sich entsprechenden Bezugszeichen versehen.

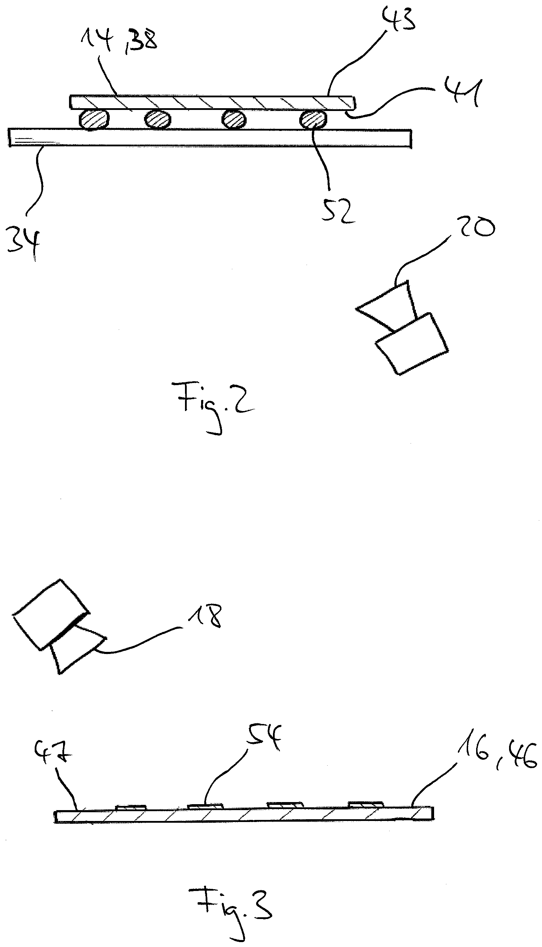

Figur 1 zeigt eine schematische Darstellung der erfindungsgemäßen Vorrichtung 10 zur Platzierung von in Figur 2 gezeigten elektronischen Bauteilen 14 auf einer in Figur 3 gezeigten Platine 16 beim Einlernen oder Teachen der Vorrichtung 10. Die Vorrichtung 10 weist zwei Kameras 18, 20 auf. Ferner weist die Vorrichtung 10 eine Steuereinrichtung 22 mit einer Speichereinrichtung 24 auf.

Die Vorrichtung 10 weist darüber hinaus eine Greifeinrichtung 26 zum Greifen der zu platzierenden Bauteile 14 sowie eine Antriebseinheit 28 zum Verfahren der Greifeinrichtung 26 entlang von wenigstens 3-Achsen auf. Figur 1 zeigt schematisch zwei Verfahrrichtungen, wobei eine Verfahrrichtung in einer Z-Richtung durch einen Pfeil 30 gekennzeichnet ist und wobei eine Verfahrrichtung in einer X- oder Y-Richtung durch einen Pfeil 32 gekennzeichnet ist. Die Antriebseinheit 28 ist von der Steuereinrichtung 22 mittels einer Datenleitung 29 ansteuerbar. Die Greifeinrichtung 26 kann bspw. eine vakuumbetriebene Unterdruckgreifeinrichtung aufweisen.

Die Vorrichtung 10 weist eine Glasplatte 34 zur Platzierung der Bauteile 14 sowie einen Platinenhalter 36 zur ortsfesten Befestigung der Platinen 16 auf. Der Platinenhalter 36 kann dazu bspw. in den Figuren nicht gezeigte Halteklammern aufweisen.

Die erfindungsgemäße Vorrichtung 10 funktioniert nun wie folgt:
Wenn Bauteile 14 eines ersten Bauteiltyps auf einer Platine 16 eines ersten Platinenbereichstyps platziert werden sollen, ist zunächst ein sogenanntes Einlernen oder Teachen der Vorrichtung 10 erforderlich.

Hierzu wird ein Referenzbauteil 38 des ersten Bauteiltyps auf der Glasplatte 34 durch einen Anwender manuell in einer Referenzstartposition 40, welche in Figur 1 gestrichelt gekennzeichnet ist, platziert. In der Referenzstartposition 40 wird dann mittels der ersten Kamera 20 ein Referenzbauteilbild des Referenzbauteils 38 von einer Bauteilunterseite 41 erstellt.

Anschließend wird das Referenzbauteil 38 von der Greifeinrichtung 26 an einer Bauteiloberseite 43 gegriffen und manuell durch einen Anwender mittels der Antriebseinheit 28 entlang eines Referenzverfahrwegs, der sich aus einer Rotation und einer Translation zusammensetzt, von der Referenzstartposition 38 in eine Referenzendposition 44 auf einer Referenzplatine 46 des ersten Platinenbereichstyps verfahren und dort abgesetzt. Die Translation ist in Figur 1 durch einen Pfeil 42 gekennzeichnet.

Von der Referenzplatine 46, die am Platinenhalter 36 ortsfest befestigt ist, wird mittels der zweiten Kamera 18 ein Referenzplatinenbereichsbild der Referenzplatine 46 von der Platinenoberseite 47 erstellt.

Das Referenzbauteilbild, die Referenzstartposition 40, der Referenzverfahrweg sowie das Referenzplatinenbereichsbild werden in der Speichereinrichtung 24 der Steuereinrichtung 22 abgespeichert. Dieser Schritt wird auch als sogenanntes Einlernen oder Teachen bezeichnet.

Die Bewegung des Referenzbauteils 38 von der Referenzstartposition 40 in die Referenzendposition 44, d.h. der Referenzverfahrweg, umfasst eine Rotation des Referenzbauteils 38 um einen Rotationsmittelpunkt 48 in Richtung des Pfeils 50 bis die in Figur 1 mit einer durchgezogenen Linie gezeigte Position 52 des Referenzbauteils 38 erreicht ist. Die Bewegung des Referenzbauteils 38 von der Referenzstartposition 40 in die Referenzendposition 44, d.h. der Referenzverfahrweg, umfasst ferner die Translation, die in Figur 1 beispielhaft durch den Pfeil 42, zwischen den Rotationsmittelpunkten 48 gezeigt ist. In der Referenzendposition 44 werden Kotaktflächen 52 des Referenzbauteils 38 mit Kontaktflächen 54 der Referenzplatine 46 derart überlagert, dass eine gegenseitige Kontaktierung der Kontaktflächen 52, 54 erfolgt, wenn das Referenzbauteil 38 mittels der Antriebseinheit 28 auf die Referenzplatine 46 abgesenkt wird.

Zur automatischen Platzierung eines zu platzierenden Bauteils 14 des ersten Bauteiltyps auf einer Platine 16 des ersten Platinenbereichstyps wird nach dem Einlernen oder Teachen wiederum ein Bauteil 14 des ersten Bauteiltyps von einem Anwender, wie in Figur 2 gezeigt, auf der Glasplatte 34 in einer Startposition aufgelegt. Anschließend wird mittels der ersten Kamera 20 ein Bauteilbild von der Bauteilunterseite 41 erstellt.

Ferner wird eine Platine 16 des ersten Platinenbereichstyps auf dem Platinenhalter 38 ortsfest befestigt und es wird, wie in Figur 3 gezeigt ist, ein Platinenbereichsbild der Platine 16 des ersten Platinenbereichstyps von der Platinenoberseite 47 erstellt.

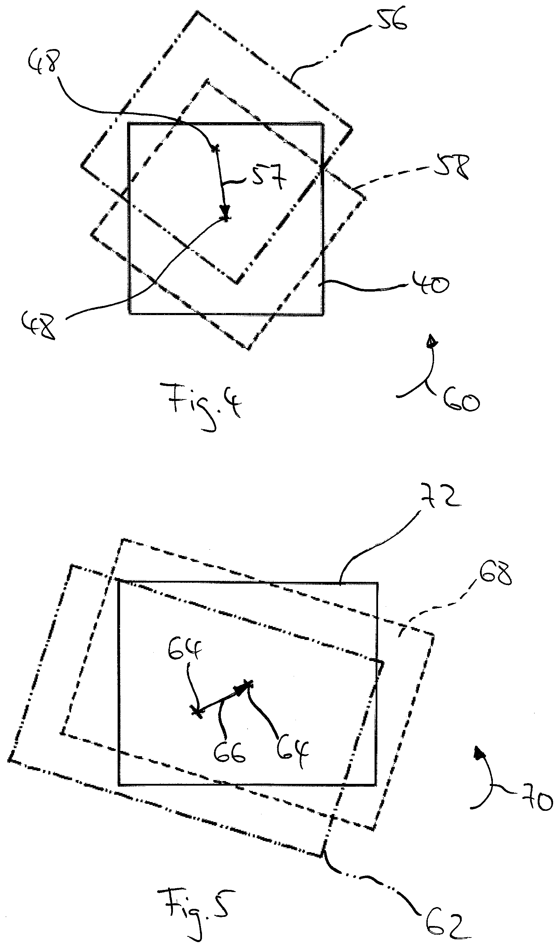

Anschließend erfolgt eine Berechnung eines Verfahrwegs zum Verfahren des zu platzierenden Bauteils 14 von der Startposition in eine Endposition auf der Platine 16. Diese Berechnung erfolgt basierend auf einer in Figur 4 schematisch gezeigten Bildüberlagerung des Bauteilbilds in der Startposition und des zuvor abgespeicherten Referenzbauteilbilds in der zuvor abgespeicherten Referenzstartposition 40.

Die Berechnung des Verfahrwegs erfolgt ferner basierend auf dem zuvor abgespeicherten Referenzverfahrweg des Referenzbauteils 38 von der Referenzstartposition 40 in die Referenzendposition 44 auf der Referenzplatine 46 des ersten Platinenbereichstyps, der sich aus der Translation entlang des Pfeils 42 sowie der Rotation um den Rotationsmittelpunkt 48 in Richtung des Pfeils 50 zusammensetzt.

Darüber hinaus erfolgt die Berechnung des Verfahrwegs basierend auf einer in Figur 5 schematisch gezeigten Bildüberlagerung des Platinenbereichsbilds und des zuvor abgespeicherten Referenzplatinenbereichsbilds.

In Figur 4 ist ein Bauteilbild 56 eines zu platzierenden Bauteils 16 schematisch strichpunktiert gezeigt. Auf Basis einer Bildüberlagerung, welche auf einem an sich bekannten Bilderkennungsverfahren beruht, erfolgt eine sich aus einer Rotation und einer Translation zusammensetzende Bewegung.

Der Rotationsmittelpunkt 48 des Bauteilbilds 56 wird zunächst mit dem Rotationsmittelpunkt 48 des Referenzbauteilbilds durch eine Translation, die durch einen Pfeil 57 gekennzeichnet ist, in Überlagerung gebracht. Dieser Zwischenschritt ist in Figur 4 gestrichelt dargestellt und trägt das Bezugszeichen 58. Anschließend erfolgt eine Rotation um den Rotationsmittelpunkt 48 in Richtung des Pfeils 60 bis das Bauteilbild 56 und das Referenzbauteilbild in der Referenzstartposition 40 sich exakt überlagern. Diese Situation ist in Figur 4 mit einer durchgezogenen Linie gekennzeichnet.

Figur 5 wiederum zeigt analog hierzu eine Überlagerung eines Platinenbereichsbilds 62 und des zuvor abgespeicherten Referenzplatinenbereichsbilds, welche ebenso auf dem bekannten Bilderkennungsverfahren beruht. Es erfolgt ebenfalls eine sich aus einer Rotation und einer Translation zusammensetzende Bewegung.

Figur 5 zeigt hierzu das Platinenbereichsbild 62 einer Platine 16 des ersten Platinenbereichstyps, das schematisch strichpunktiert gezeigt ist. Ein Rotationsmittelpunkt 64 des Platinenbereichsbilds 62 wird zunächst mit dem Rotationsmittelpunkt 48 des Referenzplatinenbereichsbilds in Überlagerung gebracht. Diese Überlagerung erfolgt durch eine Translation, die durch einen Pfeil 66 gekennzeichnet ist. Dieser Zwischenschritt ist in Figur 5 gestrichelt dargestellt und trägt das Bezugszeichen 68. Anschließend erfolgt eine Rotation um den Rotationsmittelpunkt 64 in Richtung eines Pfeils 70 bis das Platinenbereichsbild 62 und das Referenzplatinenbereichsbild sich exakt überlagern. Diese Situation ist in Figur 5 mit einer durchgezogenen Linie gekennzeichnet und trägt das Bezugszeichen 72.

Die Berechnung des Verfahrwegs erfolgt schließlich durch eine Koordinatentransformation und setzt sich aus einer Rotation und Translation der Bildüberlagerung von Bauteilbild 56 und Referenzbauteilbild, einer Rotation und Translation des Referenzverfahrwegs, sowie einer Rotation und Translation der Bildüberlagerung von Platinenbereichsbild 62 und Referenzplatinenbereichsbild zusammen.

Nach der Berechnung des Verfahrwegs wird die Platine 16 an der Startposition von der Greifeinrichtung 26 gegriffen und mittels der Antriebseinheit 28, die von der Steuereinrichtung 22 angesteuert wird, entlang des Verfahrwegs in X/Y-Richtung in die Endposition auf der Platine 16 verfahren und in Z-Richtung auf die Platine 16 abgesenkt.

Dadurch, dass die Bildüberlagerung jeweils zwischen Bauteilbild 56 und Referenzbauteilbild eines identischen Bauteiltyps, sowie zwischen Platinenbereichsbild 62 und Referenzplatinenbereichsbild eines identischen Platinenbereichstyps erfolgt, können äußere Störeinflüsse auf die Bildüberlagerung minimiert werden, wobei eine automatische Platzierung der Bauteile 14 auf der Platine 16 auf einfache und präzise Art und Weise ermöglicht wird.

## Patentansprüche

1. Verfahren zur Platzierung elektronischer Bauteile (14) auf einer Platine (16) umfassend die folgenden Schritte:
- Platzieren eines zu platzierenden Bauteils (14) eines ersten Bauteiltyps in einer Startposition;
- Erstellen eines Bauteilbilds (56) des zu platzierenden Bauteils (14);
- Erstellen eines Platinenbereichsbilds (62) einer Platine (16) eines ersten Platinenbereichstyps;
- Berechnen eines Verfahrwegs zum Verfahren des zu platzierenden Bauteils (14) von der Startposition in eine Endposition auf der Platine (16) basierend auf
einer Bildüberlagerung des Bauteilbilds (56) und eines zuvor abgespeicherten Referenzbauteilbilds eines Referenzbauteils (38) des ersten Bauteiltyps und basierend auf
einer zuvor abgespeicherten Referenzstartposition, einem zuvor abgespeicherten Referenzverfahrweg des Referenzbauteils (38) von der Referenzstartposition (40) in eine Referenzendposition (44) auf einer Referenzplatine (46) des ersten Platinenbereichstyps und basierend auf
einer Bildüberlagerung des Platinenbereichsbilds (62) und eines zuvor abgespeicherten Referenzplatinenbereichsbilds der Referenzplatine (46);
- Verfahren des zu platzierenden Bauteils (14) in die Endposition entlang des Verfahrwegs, **dadurch gekennzeichnet, dass** vor dem Abspeichern des Referenzbauteilbilds und der Referenzstartposition (40) ein Referenzbauteilbild erstellt wird und ein Referenzbauteil (38) in der Referenzstartposition (40) platziert wird, wobei das Referenzbauteil (38) dann entlang des Referenzverfahrwegs von der Referenzstartposition (40) in die Referenzendposition (44) auf der Referenzplatine (46) verfahren wird und wobei der Referenzverfahrweg abgespeichert wird, wenn das Referenzbauteil (38) in der Referenzendposition (44) angelangt ist.

2. Verfahren nach Anspruch 1, **dadurch gekennzeichnet, dass** das Verfahren des Referenzbauteils (38) von der Referenzstartposition (40) in die Referenzendposition (44) manuell erfolgt.

3. Verfahren nach Anspruch 1 oder 2, **dadurch gekennzeichnet, dass** die Berechnung des Verfahrwegs durch eine Koordinatentransformation erfolgt und sich aus einer Rotation und Translation der Bildüberlagerung von Bauteilbild (56) und Referenzbauteilbild, einer Rotation und Translation des Referenzverfahrwegs sowie einer Rotation und Translation der Bildüberlagerung von Platinenbereichsbild (62) und Referenzplatinenbereichsbild zusammensetzt.

4. Verfahren nach wenigstens einem der vorhergehenden Ansprüche, **dadurch gekennzeichnet, dass** das zu platzierende Bauteil (14) vor dem Verfahren von einer Greifeinrichtung (26) gegriffen und angehoben wird.

5. Verfahren nach wenigstens einem der vorhergehenden Ansprüche, **dadurch gekennzeichnet, dass** das zu platzierende Bauteil (14) nach dem Verfahren auf der Platine (16) in der Endposition abgesetzt wird oder in der Endposition auf die Platine (16) fallen gelassen wird.

6. Verfahren nach wenigstens einem der vorhergehenden Ansprüche, **dadurch gekennzeichnet, dass** das Platzieren des Bauteils (14) in der Startposition auf einer Glasplatte (34) erfolgt.

7. Verfahren nach wenigstens einem der vorhergehenden Ansprüche, **dadurch gekennzeichnet, dass** das Bauteilbild (56) und das Referenzbauteilbild von einer Bauteilunterseite (41) aufgenommen werden.

8. Verfahren nach wenigstens einem der vorhergehenden Ansprüche, **dadurch gekennzeichnet, dass** das Platinenbereichsbild (62) und das
Referenzplatinenbereichsbild von einer Platinenoberseite (47) aufgenommen werden.

9. Verfahren nach wenigstens einem der vorhergehenden Ansprüche, **dadurch gekennzeichnet, dass** das Bauteilbild (56) des zu platzierenden Bauteils (14) und/oder das Referenzbauteilbild des Referenzbauteils (38) in der Startposition erstellt wird.

10. Vorrichtung (10) zur Platzierung elektronischer Bauteile welche dazu eingerichtet ist, das Verfahren nach wenigstens einem der Ansprüche 1 bis 10 auszuführen, wobei die Vorrichtung (10) wenigstens eine, vorzugsweise zwei Kameras (18, 20)aufweist, die zum Erstellen des Bauteilbilds (56), des Referenzbauteilbilds, des Platinenbereichsbilds (62) und des Referenzplatinenbereichsbilds eingerichtet sind, dass die Vorrichtung (10) eine Steuereinrichtung (22) aufweist, die zur Berechnung des Verfahrwegs eingerichtet ist, dass die Steuereinrichtung (22) eine Speichereinrichtung (24) aufweist, die zur Abspeicherung des Referenzbauteilbilds, der Referenzstartposition (40), des Referenzverfahrwegs und des Referenzplatinenbereichsbilds eingerichtet ist und dass die Vorrichtung eine Greifeinrichtung (26) zum Greifen der zu platzierenden Bauteile (14) aufweist, **dadurch gekennzeichnet, dass** die Vorrichtung (10) eine Glasplatte (34) zur Platzierung der Bauteile (14) in der Startposition aufweist.

11. Vorrichtung (10) nach Anspruch 10, **dadurch gekennzeichnet, dass** die Vorrichtung (10) eine Antriebseinheit (28) aufweist, die zum Verfahren der Greifeinrichtung (26) entlang des Verfahrwegs ausgelegt ist.

12. Vorrichtung (10) nach Anspruch 10 oder 11, **dadurch gekennzeichnet, dass** die Greifeinrichtung (26) eine vakuumbetriebene Unterdruckgreifeinrichtung aufweist.

13. Vorrichtung (10) nach wenigstens einem der Ansprüche 10 bis 12, **dadurch gekennzeichnet, dass** die Vorrichtung (10) einen Platinenhalter (36) aufweist, der zur ortsfesten Befestigung der Platinen (16) ausgelegt ist.

## Claims

1. Method for placing electronic components (14) onto a circuit board (16), comprising the following steps:
- Placing a component to be placed (14) of a first component type into a starting position;
- Creating a component image (56) of the component to be placed (14);
- Creating a circuit board region image (62) of a circuit board (16) of a first circuit board region type;
- Calculating a travel path for moving the component to be placed (14) from a starting position into a final position on the circuit board (16) based upon
an image overlay of the component image (56) and a previously saved reference component image of a reference component (38) of the first component type, and based upon
a previously saved reference starting position, a previously saved reference travel path of the reference component (38) from the reference starting position (40) into a reference final position (44) on a reference circuit board (46) of the first circuit board region type, and based upon
an image overlay of the circuit board region image (62) and a previously saved reference circuit board region image of the reference circuit board (46);
- Moving the component to be placed (14) along the travel path into the final position
**characterized in that**
a reference component image is created prior to saving the reference component image and the reference starting position (40), and a reference component (38) is placed into the reference starting position (40), wherein the reference component (38) is then moved along the reference travel path from the reference starting position (40) into the reference final position (44) on the reference circuit board (46), and wherein the reference travel path is saved when the reference component (38) arrives at the reference final position (44).

2. Method according to claim 1, **characterized in that** the reference component (38) is moved manually from the reference starting position (40) into the reference final position (44).

3. Method according to claim 1 or 2, **characterized in that** the calculation of the travel path is performed by means of a coordinate transformation and consists of a rotation and translation of the image overlay of the component image (56) and the reference component image, a rotation and translation of the reference travel path, as well as a rotation and translation of the image overlay of the circuit board region image (62) and the reference circuit board region image.

4. Method according to at least one of the preceding claims, **characterized in that** the component to be placed (14) is gripped and lifted by a gripping device (26) prior to being moved.

5. Method according to at least one of the preceding claims, **characterized in that**, after the movement, the component to be placed (14) is deposited onto the circuit board (16) into the final position or is dropped into the final position on the circuit board (16).

6. Method according to at least one of the preceding claims, **characterized in that** the component (14) is placed into the starting position on a glass plate (34).

7. Method according to at least one of the preceding claims, **characterized in that** the component image (56) and the reference component image are taken of a component bottom side (41).

8. Method according to at least one of the preceding claims, **characterized in that** the circuit board region image (62) and the reference circuit board region image are taken of a circuit board top side (47).

9. Method according to at least one of the preceding claims, **characterized in that** the component image (56) of the component to be placed (14) and/or the reference component image of the reference component (38) is created in the starting position.

10. Device (10) for placing electronic components, which is designed to perform the method according to at least one of claims 1 through 9, wherein the device (10) comprises at least one, and preferably, two, cameras (18, 20) designed to create the component image (56), the reference component image, the circuit board region image (62), and the reference circuit board region image, that the device (10) comprises a control unit (22) designed to calculate the travel path, that the control unit (22) comprises a storage unit (24) designed to store the reference component image, the reference starting position (40), the reference travel path, and the reference circuit board region image, and that the device comprises a gripping device (26) for gripping the components to be placed (14) **characterized in that** the device (10) comprises a glass plate (34) for placing the components (14) into the starting position.

11. Device (10) according to claim 10, **characterized in that** the device (10) comprises a drive unit (28) that is designed to move the gripping device (26) along the travel path.

12. Device (10) according to claim 10 or 11, **characterized in that** the gripping device (26) comprises a vacuum-operated, low-pressure gripping device.

13. Device (10) according to at least one of claims 10 through 12, **characterized in that** the device (10) comprises a circuit board holder (36) that is designed for the stationary mounting of the circuit boards (16).

## Revendications

1. Procédé de mise en place de composants électroniques (14) sur une carte de circuits imprimés (16) comportant les étapes suivantes :
- la mise en place d'un composant (14) à mettre en place d'un premier type de composant dans une position de départ ;
- la création d'une image de composant (56) du composant (14) à mettre en place ;
- la création d'une image de zone de carte de circuits imprimés (62) d'une carte de circuits imprimés (16) d'un premier type de zone de carte de circuits imprimés ;
- le calcul d'une voie de déplacement pour le déplacement du composant (14) à mettre en place de la position de départ dans une position finale sur la carte de circuits imprimés (16) sur la base
d'une superposition d'images de l'image de composant (56) et d'une image de composant de référence préalablement mise en mémoire d'un composant de référence (38) du premier type de composant et sur la base
d'une position de départ de référence préalablement mise en mémoire, d'une voie de déplacement de référence préalablement mise en mémoire du composant de référence (38) de la position de départ de référence (40) dans une position finale de référence (44) sur une carte de circuits imprimés de référence (46) du premier type de zone de carte de circuits imprimés et sur la base
d'une superposition d'images de l'image de zone de carte de circuits imprimés (62) et d'une image de zone de carte de circuits imprimés de référence préalablement mise en mémoire de la carte de circuits imprimés de référence (46) ;
- le déplacement du composant (14) à mettre en place dans la position finale le long de la voie de déplacement, **caractérisé en ce que**, avant la mise en mémoire de l'image de composant de référence et de la position de départ de référence (40), une image de composant de référence est créée et un composant de référence (38) est mis en place dans la position de départ de référence (40), dans lequel le composant de référence (38) est alors déplacé le long de la voie de déplacement de référence de la position de départ de référence (40) dans la position finale de référence (44) sur la carte de circuits imprimés de référence (46) et dans lequel la voie de déplacement de référence est mise en mémoire lorsque le composant de référence (38) est parvenue dans la position finale de référence (44) .

2. Procédé selon la revendication 1, **caractérisé en ce que** le déplacement du composant de référence (38) de la position de départ de référence (40) dans la position finale de référence (44) s'effectue manuellement.

3. Procédé selon la revendication 1 ou 2, **caractérisé en ce que** le calcul de la voie de déplacement s'effectue par l'intermédiaire d'une transformation de coordonnées et se compose d'une rotation et d'une translation de la superposition d'images de l'image de composant (56) et de l'image de composant de référence, d'une rotation et d'une translation de la voie de déplacement de référence ainsi que d'une rotation et d'une translation de la superposition d'images de l'image de zone de carte de circuits imprimés (62) et de l'image de zone de carte de circuits imprimés de référence.

4. Procédé selon au moins l'une des revendications précédentes, **caractérisé en ce que** le composant (14) à mettre en place est saisi et soulevé avant le déplacement par un système de préhension (26).

5. Procédé selon au moins l'une des revendications précédentes, **caractérisé en ce que** le composant (14) à mettre en place est déposé après le déplacement sur la carte de circuits imprimés (16) dans la position finale ou laissé tomber sur la carte de circuits imprimés (16) dans la position finale.

6. Procédé selon au moins l'une des revendications précédentes, **caractérisé en ce que** la mise en place du composant (14) s'effectue sur une plaque de verre (34) dans la position de départ.

7. Procédé selon au moins l'une des revendications précédentes, **caractérisé en ce que** l'image de composant (56) et l'image de composant de référence sont acquises par une face inférieure de composant (41).

8. Procédé selon au moins l'une des revendications précédentes, **caractérisé en ce que** l'image de zone de carte de circuits imprimés (62) et l'image de zone de carte de circuits imprimés de référence sont acquises par une face supérieure de carte de circuits imprimés (47).

9. Procédé selon au moins l'une des revendications précédentes, **caractérisé en ce que** l'image de composant (56) du composant (14) à mettre en place et/ou l'image de composant de référence du composant de référence (38) sont créées dans la position de départ.

10. Dispositif (10) pour la mise en place de composants électroniques, lequel est conçu pour réaliser le déplacement selon au moins l'une des revendications 1 à 10, dans lequel le dispositif (10) comprend au moins une, de préférence deux caméras (18, 20), qui sont conçues pour créer l'image de composant (56), l'image de composant de référence, l'image de zone de carte de circuits imprimés (62) et l'image de zone de carte de circuits imprimés de référence, en ce que le dispositif (10) comprend un système de commande (22), qui est conçu pour calculer la voie de déplacement, en ce que le système de commande (22) comprend un système mémoire (24), qui est conçu pour mettre en mémoire l'image de composant de référence, la position de départ de référence (40), la voie de déplacement de référence et l'image de zone de carte de circuits imprimés de référence et en ce que le dispositif comprend un système de préhension (26) destiné à saisir les composants (14) à mettre en place, **caractérisé en ce que** le dispositif (10) comprend une plaque de verre (34) pour la mise en place des composants (14) dans la position de départ.

11. Dispositif (10) selon la revendication 10, **caractérisé en ce que** le dispositif (10) comprend une unité d'entraînement (28), qui est configurée pour déplacer le système de préhension (26) le long de la voie de déplacement.

12. Dispositif (10) selon la revendication 10 ou 11, **caractérisé en ce que** le système de préhension (26) comprend un système de préhension par succion fonctionnant sous vide.

13. Dispositif (10) selon au moins l'une des revendications 10 à 12, **caractérisé en ce que** le dispositif (10) comprend un porte-carte de circuits imprimés (36), qui est configuré pour la fixation immobile des cartes de circuits imprimés (16).
